# EUROPEAN PATENT APPLICATION

(11) **EP 4 712 374 A1**
(43) Date of publication of application: **18.03.2026**
(21) Application number: 24830772.0
(22) Date of filing: 25.06.2024
(51) Int. Cl.: H04L 1/00

(54) **DATA STREAM DEINTERLEAVING METHOD, DEVICE, AND SYSTEM**

(30) Priority: 27.06.2023 CN 202310773216; 03.07.2023 CN 202310808219; 16.01.2024 CN 202410063609
(71) Applicant: Huawei Technologies Co., Ltd., Shenzhen, Guangdong 518129 (CN)
(72) Inventor: HE, Xiang, Shenzhen, Guangdong 518129 (CN); REN, Hao, Shenzhen, Guangdong 518129 (CN)
(74) Representative: Huawei European IPR
(86) International application number: PCT/CN2024/101414
(87) International publication number: WO 2025/002132

(57) **Abstract**

A data stream de-interleaving method is provided. The method includes: obtaining a first interleaved data stream on which forward error correction FEC encoding is performed; obtaining, based on an interleaving granularity of the first interleaved data stream, N sub-data streams corresponding to the first interleaved data stream, where N is an interleaving depth of the first interleaved data stream, and N is a positive integer greater than 1; determining a de-interleaving position based on FEC codeword boundaries of at least two of the N sub-data streams; and obtaining a first de-interleaved data stream based on the de-interleaving position and the first interleaved data stream. According to the method, de-interleaving can be completed and data can be correctly restored without inserting additional fixed data segments dedicated to searching for the de-interleaving position. In this way, adding of additional data is avoided, hardware resources are saved, de-interleaving efficiency is improved, transmission costs are reduced, and network efficiency is improved.

## Description

This application claims priorities to Chinese Patent Application No. 202410063609.7, filed on January 16, 2024 and entitled "DATA STREAM DE-INTERLEAVING METHOD, DEVICE, AND SYSTEM", to Chinese Patent Application No. 202310773216.0, filed on June 27, 2023 and entitled "SYNCHRONIZATION METHOD FOR DE-INTERLEAVING", and to Chinese Patent Application No. 202310808219.3, filed on July 3, 2023 and entitled "DATA STREAM DE-INTERLEAVING METHOD, DEVICE, AND SYSTEM", which are incorporated herein by reference in their entireties.

### TECHNICAL FIELD

This application relates to the communication field, and in particular, to a data stream de-interleaving method, a device, and a system.

### BACKGROUND

In an Ethernet data transmission process, due to various factors such as environmental interference and system errors, data received by a data receiver is inconsistent with data sent by a data transmitter. That is, a bit error is inevitable. Currently, a bit error rate (bit error rate, BER) can be reduced by using forward error correction (Forward Error Correction, FEC), an interleaver (interleaver), and other means. Data output by the interleaver is transmitted to the data receiver through a communication channel, and is input to a de-interleaver at the data receiver for de-interleaving, and then de-interleaved data enters an FEC decoder for decoding.

To determine a correct de-interleaving position, the data transmitter typically periodically inserts, into data, fixed data segments dedicated to determining the de-interleaving position, and the data receiver determines the correct de-interleaving position by searching for these fixed data segments. However, in this manner, the fixed data segments need to be additionally transmitted in addition to original data to be transmitted, resulting in higher transmission costs.

### SUMMARY

A data stream de-interleaving method is provided, to resolve technical problems of low de-interleaving efficiency and low network transmission efficiency caused by insertion of fixed data segments.

According to a first aspect, a data stream de-interleaving method is provided. The method includes: obtaining a first interleaved data stream on which forward error correction FEC encoding is performed; obtaining, based on an interleaving granularity of the first interleaved data stream, N sub-data streams corresponding to the first interleaved data stream, where N is an interleaving depth of the first interleaved data stream, and N is a positive integer greater than 1; determining a de-interleaving position based on FEC codeword boundaries of at least two of the N sub-data streams; and obtaining a first de-interleaved data stream based on the de-interleaving position and the first interleaved data stream. The de-interleaving position may also be referred to as a correct de-interleaving position, that is, is used to correctly perform a de-interleaving process, and restore original codewords and a relative sequence of the original codewords, to restore a position of a data stream before the encoding. According to the method, de-interleaving can be completed and data can be correctly restored without inserting additional fixed data segments dedicated to searching for the de-interleaving position. In this way, adding of additional data is avoided, hardware resources are saved, de-interleaving efficiency is improved, transmission costs are reduced, and network efficiency is improved.

In a possible implementation, the N sub-data streams are arranged in sequence, and the determining a de-interleaving position based on FEC codeword boundaries of at least two of the N sub-data streams includes: determining, based on an FEC codeword boundary of a first sub-data stream being after an FEC codeword boundary of a second sub-data stream, that the de-interleaving position is the FEC codeword boundary of the second sub-data stream, where the first sub-data stream and the second sub-data stream are two adjacent sub-data streams in the N sub-data streams. A sequence of the FEC codeword boundaries is a sequence of transmitting data at positions of the FEC codeword boundaries of the first interleaved data stream, or is referred to as a fast-slow sequence. When it is found that there is an interval between FEC codeword boundaries of two adjacent sub-data streams, a sub-data stream whose FEC codeword boundary is ahead is a sub-data stream transmitted faster, and the FEC codeword boundary of the sub-data stream transmitted faster is a correct de-interleaving position.

In a possible implementation, the first sub-data stream is before the second sub-data stream in an arrangement sequence.

In a possible implementation, there is an interval of one symbol between the FEC codeword boundary of the first sub-data stream and the FEC codeword boundary of the second sub-data stream.

In a possible implementation, the N sub-data streams are arranged in sequence, and the determining a de-interleaving position based on FEC codeword boundaries of at least two of the N sub-data streams includes: determining, based on alignment of FEC codeword boundaries of all of the N sub-data streams, that the de-interleaving position is an FEC codeword boundary of a first sub-data stream, where the first sub-data stream has a highest ranking in the N sub-data streams in an arrangement sequence. That FEC codeword boundaries of all sub-data streams are aligned means that data at the position of the FEC codeword boundary of each sub-data stream is in data corresponding to one de-interleaving distribution, that is, the data at the position of the FEC codeword boundary of each sub-data stream is in data corresponding to a group of interleaving at the data transmitter. When it is found that the FEC codeword boundaries of the sub-data streams are aligned, the current position where the de-interleaving distribution starts is the correct de-interleaving position, that is, the FEC codeword boundary of the sub-data stream that has a highest ranking in the N sub-data streams in an arrangement sequence is the correct de-interleaving position.

In a possible implementation, the obtaining a first de-interleaved data stream based on the de-interleaving position and the first interleaved data stream includes: determining a de-interleaving and combination sequence of the N sub-data streams based on the de-interleaving position and the arrangement sequence of the N sub-data streams; and combining data of the first interleaved data stream based on the de-interleaving and combination sequence, to obtain the first de-interleaved data stream.

In a possible implementation, the obtaining, based on an interleaving granularity of the first interleaved data stream, N sub-data streams corresponding to the first interleaved data stream includes: selecting a data stream distribution start position from the first interleaved data stream, and distributing the first interleaved data stream to the N sub-data streams based on the interleaving granularity of the first interleaved data stream, where the data stream distribution start position is a position randomly selected from the first interleaved data stream.

In a possible implementation, the obtaining, based on an interleaving granularity of the first interleaved data stream, N sub-data streams corresponding to the first interleaved data stream includes: distributing the data of the first interleaved data stream to the N sub-data streams in a round-robin manner based on the interleaving granularity of the first interleaved data stream.

In a possible implementation, the method further includes: determining an FEC codeword boundary of each of the N sub-data streams.

In a possible implementation, the determining an FEC codeword boundary of each of the N sub-data streams includes: determining the FEC codeword boundary of each of the N sub-data streams based on an FEC codeword characteristic.

In a possible implementation, the determining the FEC codeword boundary of each of the N sub-data streams based on an FEC codeword characteristic includes: in each sub-data stream, separately performing characteristic value verification based on an assumed FEC codeword boundary, and determining the FEC codeword boundary of each sub-data stream based on a verification result.

In a possible implementation, there is a cyclic shift relationship between FEC codewords of the N sub-data streams, and the determining the FEC codeword boundary of each of the N sub-data streams based on an FEC codeword characteristic includes: performing an inverse cyclic shift on the obtained FEC codewords of the N sub-data streams; and determining the FEC codeword boundary of each of the N sub-data streams after the inverse cyclic shift based on the FEC codeword characteristic.

In a possible implementation, the first interleaved data stream does not include a periodic alignment data segment, and the periodic alignment data segment includes an alignment marker, a frame alignment word, or pilot data.

In a possible implementation, an FEC encoding mode of the first interleaved data stream is FEC encoding of a non-concatenated code or FEC encoding of a concatenated code.

In a possible implementation, N is 4 or 8.

In a possible implementation, an interleaving type of the first interleaved data stream is symbol interleaving or convolutional interleaving.

In a possible implementation, the method is performed by a physical layer PHY chip, a forwarding device, or a pluggable module.

In a possible implementation, a lane rate of the first interleaved data stream is greater than or equal to 200 gigabits per second Gbps.

According to a second aspect, an Ethernet device is provided, including at least one module. The at least one module is configured to perform the method provided in any one of the first aspect or the optional manners of the first aspect. The at least one module may be implemented based on software, hardware, or a combination of software and hardware, and the module may be randomly combined or divided based on specific implementation.

According to a third aspect, an Ethernet device is provided, including a memory and a processor. The memory is configured to store a computer program. The processor is configured to execute the computer program stored in the memory, to enable the Ethernet device to perform the method provided in any one of the first aspect or the optional manners of the first aspect.

According to a fourth aspect, an Ethernet device is provided, including a main control board and an interface board. The main control board or the interface board is configured to implement the method provided in any one of the first aspect or the optional manners of the first aspect.

According to a fifth aspect, a communication system is provided. The communication system includes a transmitter device and a receiver device, and the receiver device is configured to perform the method provided in any one of the first aspect or the optional manners of the first aspect.

According to a sixth aspect, a computer-readable storage medium is provided. The computer-readable storage medium stores a computer program. When the computer program is executed, the method provided in any one of the first aspect or the optional manners of the first aspect is implemented.

According to a seventh aspect, a computer program product is provided. The computer program product includes a program or code. When the program or the code is executed, the method provided in any one of the first aspect or the optional manners of the first aspect is implemented.

According to an eighth aspect, a chip is provided. When the chip runs, the method provided in any one of the first aspect or the optional manners of the first aspect is implemented. The chip may be a control chip or a forwarding chip, and the chip includes a programmable logic circuit and/or program instructions.

For technical effects of the second aspect to the eighth aspect, refer to technical effects of the first aspect. Details are not described herein again.

### BRIEF DESCRIPTION OF DRAWINGS

To describe technical solutions of this application more clearly, the following briefly describes the accompanying drawings used in embodiments. It is clear that the accompanying drawings in the following are merely accompanying drawings of some embodiments of this application, and persons of ordinary skill in the art may still derive other technical solutions and accompanying drawings from these accompanying drawings of this application without creative efforts.
FIG. 1(a) is a diagram of a random error according to an embodiment of the present invention;
FIG. 1(b) is a diagram of a random error according to an embodiment of the present invention;
FIG. 2 is a diagram of an interleaver processing process according to an embodiment of the present invention;
FIG. 3 is a diagram of an interleaved data processing process according to an embodiment of the present invention;
FIG. 4(a) is a diagram of an interleaved data processing process according to an embodiment of the present invention;
FIG. 4(b) is a diagram of an interleaved data processing process according to an embodiment of the present invention;
FIG. 5 is a diagram of an interleaved data processing process according to an embodiment of the present invention;
FIG. 6 is a diagram of a data insertion processing process according to an embodiment of the present invention;
FIG. 7 is a schematic flowchart of a data stream de-interleaving method according to an embodiment of the present invention;
FIG. 8(a) shows an applicable scenario of a data stream de-interleaving method according to an embodiment of this application;
FIG. 8(b) shows an applicable scenario of a data stream de-interleaving method according to an embodiment of this application;
FIG. 8(c) shows an applicable scenario of a data stream de-interleaving method according to an embodiment of this application;
FIG. 9 is a diagram of a cyclic shift processing process according to an embodiment of this application;
FIG. 10 is a diagram of an interleaving processing process with a cyclic shift according to an embodiment of this application;
FIG. 11 is a diagram of a data stream de-interleaving processing process according to an embodiment of this application;
FIG. 12 is a diagram of a data stream de-interleaving processing process according to an embodiment of this application;
FIG. 13 is a diagram of a data stream de-interleaving processing process according to an embodiment of this application;
FIG. 14 is a diagram of a data stream de-interleaving processing process according to an embodiment of this application;
FIG. 15 is a diagram of a structure of an Ethernet device according to an embodiment of the present invention;
FIG. 16 is a diagram of a structure of an Ethernet device according to an embodiment of the present invention; and
FIG. 17 is a diagram of a communication system according to an embodiment of the present invention.

### DESCRIPTION OF EMBODIMENTS

In a communication transmission process, due to various reasons such as environmental interference and system errors, data received by a data receiver may be inconsistent with data sent by a data transmitter. Such inconsistency is also referred to as a bit error. The bit error is inevitable in the communication transmission process. The bit error may cause many problems. For example, when a bit error exists in a key control signal exchanged between various devices in a network, serious problems such as a system crash and a data loss may be caused. In addition, the existence of the bit error greatly affects a network communication delay, and further affects experience of consumers in watching videos, online games, calls, and other activities. Therefore, a bit error rate BER is always an important performance indicator of a communication system. A smaller BER value at the data receiver indicates higher network transmission reliability.

To ensure high reliability of the communication system, a specific requirement is usually raised for the BER of the communication system in the industry. For example, the institute of electrical and electronics engineers (Institute of Electrical and Electronics Engineers, IEEE) standard 802.3bs specifies that a BER of data, received by a data receiver, entering a media access control (media access control, MAC) sublayer should be lower than 1x10⁻¹³. However, a BER of data in a network entering the data receiver after being transmitted over a network link may be typically up to 2x10⁻⁴. In this case, the data receiver may correct a bit error in the data stream through FEC, to restore the data stream to to-be-sent data. Most bit errors can be eliminated through the FEC, so that a BER of processed data is greatly reduced.

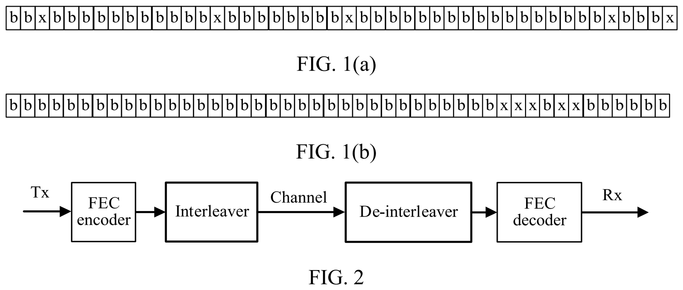

An FEC effect is related to bit error distribution. When two data streams have different bit error distribution, post-BERs of the two data streams are different even if pre-BERs of the two data streams are the same. The pre-BER is a BER before FEC, and the post-BER is a BER after FEC. There are mainly two types of bit error distribution: random error (random error) distribution and non-random error (non-random error) distribution. For intuitive description, FIG. 1(a) and FIG. 1(b) show examples of random error distribution and non-random error distribution, where b represents a bit in which data is correct, and x represents a bit in which a bit error occurs. The random error distribution shows that bit errors are randomly distributed, as shown in FIG. 1(a). The non-random distribution shows that a plurality of bit errors centrally occur in a short data sequence, as shown in FIG. 1(b). Therefore, non-random errors may also be referred to as burst errors (burst error). Burst errors are very common in actual communication networks, for example, continuous bit errors caused by decision feedback equalization (Decision Feedback Equalization, DFE) and continuous bit errors caused by fast fading due to multipath effects of radio information. As shown above, current BERs of data in FIG. 1(a) and FIG. 1(b) are the same, but different bit error distribution cause the data to have different BERs after FEC. In most communication transmission conditions, based on same pre-FEC, a post-BER of the burst error is higher than that of the random error.

For the burst error, to further reduce post-FEC, an interleaver, also referred to as a channel interleaver, is usually introduced. The use of the interleaver is shown in FIG. 2. In FIG. 2, Tx is data to be input to an FEC encoder at a data transmitter. The data is encoded by the FEC encoder at the data transmitter and then input to the interleaver for interleaving. Data output by the interleaver is transmitted to a data receiver through a communication channel. The data is input to a de-interleaver at the data receiver for de-interleaving, and then de-interleaved data enters an FEC decoder for decoding. Rx is data output by the FEC decoder at the data receiver, and through FEC and interleaving, a BER of Rx is greatly reduced.

In embodiments of this application, an interleaving manner of the interleaver may have a plurality of attributes. An interleaving type is an attribute of the interleaving manner, and the interleaving type includes symbol interleaving or convolutional interleaving. The symbol interleaving may also be referred to as block interleaving (block interleaver). The symbol interleaving and the convolutional interleaving achieve basically consistent performance in error correction, but may have different latencies and power consumption in the case of achieving equivalent error correction performance. An interleaving depth is also an attribute of the interleaving manner. The interleaving depth indicates a quantity of FEC codewords participating in the interleaving. The quantity of FEC codewords participating in the interleaving affects error correction performance.

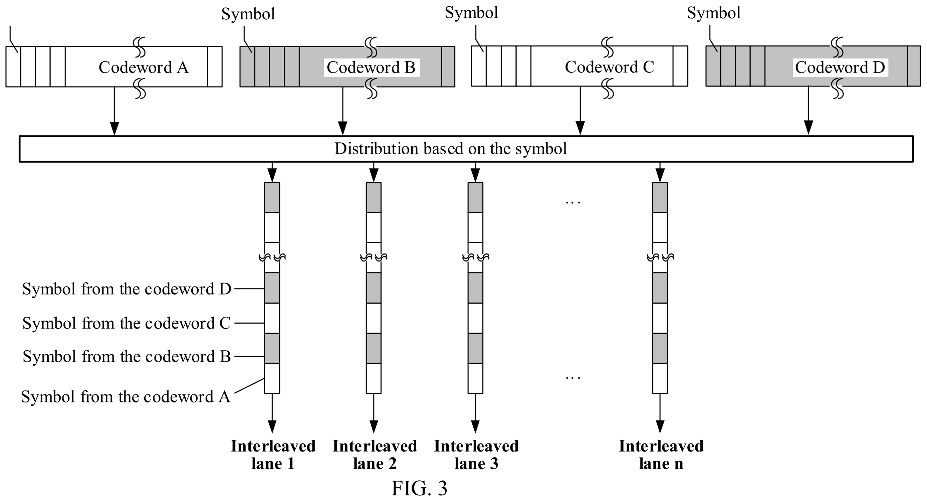

FIG. 3 is an example of a diagram of a data processing manner of symbol interleaving.

As shown in FIG. 3, a plurality of FEC-encoded codewords are obtained from a to-be-interleaved data stream as codewords participating in interleaving, for example, a codeword A, a codeword B, a codeword C, a codeword D in the figure. When the codewords participating in the interleaving are from a same data stream, interleaving is performed within the data stream; when the codewords participating in the interleaving are from different data streams, interleaving is performed between the data streams. Each codeword includes p FEC-encoded symbols (symbols), and each symbol includes q bits, that is, each codeword includes p×q bits. p and q are positive integers. For example, a length of each symbol may be 10 bits, that is, symbol interleaving is performed at a granularity of 10 bits. For another example, in pulse amplitude modulation-4 (pulse amplitude modulation-4, PAM4), a length of each symbol may be 2 bits, that is, symbol interleaving may be performed at a granularity of 2 bits in PAM4. For another example, p may alternatively be 1. To be specific, a length of each symbol may be 1 bit, that is, symbol interleaving is performed at a granularity of 1 bit. As shown in FIG. 3, four codewords are selected from a to-be-interleaved data stream to participate in interleaving, that is, an interleaving depth is four codewords. When the codeword is an RS codeword, the interleaving depth may be referred to as 4×RS. The four codewords are alternately distributed to n data streams on n lanes at a symbol granularity for output, so that adjacent symbols in each data stream come from different codewords, that is, symbols from the four codewords appear alternately. In this case, an interleaved data sequence is formed, that is, an interleaved lane 1 to an interleaved lane n shown in FIG. 3.

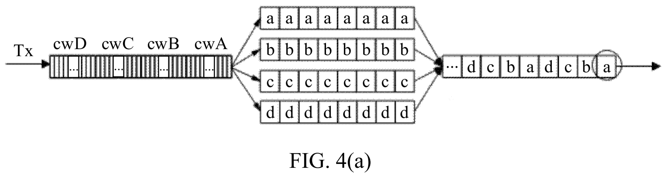

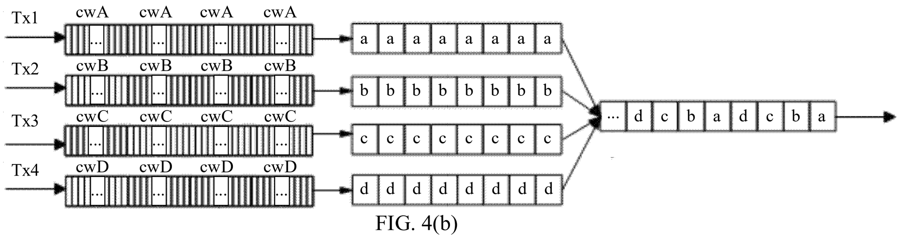

Symbol interleaving may be performed for one data stream, or may be performed for a plurality of data streams. FIG. 4(a) and FIG. 4(b) are respectively an example of a diagram of a data processing manner of performing symbol interleaving for one data stream and an example of a diagram of a data processing manner of performing symbol interleaving for a plurality of data streams.

As shown in FIG. 4(a), a to-be-interleaved data stream is a data stream Tx. Four FEC codewords are obtained from the to-be-interleaved data stream Tx to participate in interleaving, for example, cwA, cwB, cwC, cwD in FIG. 4(a). Four FEC codewords are selected for interleaving each time, that is, an interleaving depth is 4. Each codeword includes eight symbols. For example, the codeword cwA includes eight symbols, and each symbol is a, that is, the codeword cwA may be expanded to aaaaaaaa. Similarly, cwB, cwC, and cwD are expanded to bbbbbbbb, cccccccc, and dddddddd respectively. The four codewords are alternately combined at a symbol granularity, to form an interleaved data stream abcdabcdabcd ... abcd, that is, a group of interleaving is completed. Because an interleaving depth is 4, the interleaving may also be referred to as a group of 4:1 interleaving. Then, subsequent four FEC codewords are further selected for a next group of 4:1 interleaving, and so on. Details are not described.

As shown in FIG. 4(b), to-be-interleaved data streams are four data streams Tx1, Tx2, Tx3, and Tx4. One FEC codeword is selected from each of the four to-be-interleaved data streams as an FEC codeword participating in interleaving, for example, cwA, cwB, cwC, cwD respectively selected from Tx1, Tx2, Tx3, and Tx4 in FIG. 4(b). Four FEC codewords are selected for interleaving each time, that is, an interleaving depth is 4. Composition of each codeword is the same as that in FIG. 4(a). In other words, the codewords cwA, cwB, cwC, and cwD are respectively expanded to aaaaaaaa, bbbbbbbb, cccccccc, and dddddddd. The four codewords are alternately combined at a symbol granularity, to form an interleaved data stream abcdabcdabcd ... abcd. Then, subsequent four respective FEC codewords are further obtained from four to-be-interleaved data streams for interleaving, and so on. Details are not described.

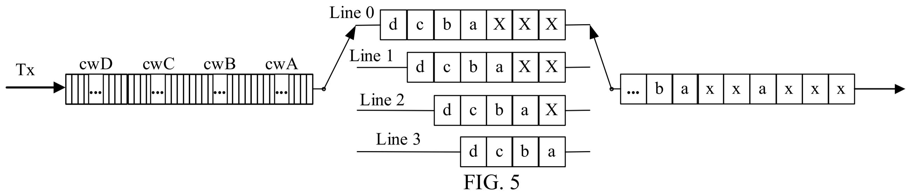

FIG. 5 is an example of a diagram of a data processing manner of convolutional interleaving. The convolutional interleaving is related to a plurality of design parameters, including a delay line number (delay line number), a delay block length (delay block length), a delay block number (delay block number), and the like. As shown in FIG. 5, a plurality of FEC-encoded codewords are obtained from a to-be-interleaved data stream to participate in interleaving, including cwA, cwB, cwC, and cwD. An interleaving depth is four codewords, in other words, four codewords, namely, the foregoing cwA, cwB, cwC, and cwD, are selected from the to-be-interleaved data stream. The delay line number is 4, namely, four data lines 0, 1, 2, and 3 from top to bottom. In FIG. 5, D represents a delay block, and each delay block is formed by a shift register (LFSR), and may temporarily store specific data, and a delay block number in each delay line is different. Each of input and output sides of an interleaver has a switchable connection switch that is used to connect to a specific delay line. Data at the FEC codewords enters the convolutional interleaver by column at a granularity of the delay block length, for example, a, b, c, and d in FIG. 5. When a length of the FEC codeword is the same as a length of the delay block, a granularity at which data enters the convolutional interleaver is the length of the FEC codeword. When a length of the FEC codeword is different from a length of the delay block, and data enters the convolutional interleaver, data of the FEC codeword needs to be adjusted to enter the convolutional interleaver at a granularity of the length of the delay block. When the input side inputs data of a delay block length, the output side also outputs data of the delay block length. Then, the switchable connection switches on both sides switch to a next delay line based on a sequence of {line 0, line 1, line 2, line 3, line 0, line 1, line 2, line 3, line 0, line 1, ...} in a round-robin manner. In addition, x on the output side in FIG. 5 represents data that is before four codewords and that is stored in a delay block. In addition, although the convolutional interleaving of one data stream is used as an example in FIG. 5, a process of convolutional interleaving between a plurality of data streams is similar to that shown in FIG. 5, and a difference lies in that codewords participating in the interleaving are from the plurality of data streams. Details are not described herein.

As described above, data output by the interleaver is transmitted to a data receiver through a communication channel, and is input to a de-interleaver at the data receiver for de-interleaving, and then de-interleaved data enters an FEC decoder for decoding. The de-interleaver may also be referred to as a channel de-interleaver. In a de-interleaving process at the data receiver, a de-interleaving position needs to be found first. The de-interleaving position may be, for example, a boundary of a 1^{st} FEC codeword in a group of interleaving, as shown in FIG. 4(a), where a position of a circle is the de-interleaving position, namely, a boundary position of the 1^{st} FEC codeword in the group of interleaving. From this position, de-interleaving may be performed on an interleaved data stream, and then combination is performed to obtain a de-interleaved data stream. It is easy to understand that the de-interleaving position periodically appears in the interleaved data stream. For example, in each group of interleaving, a boundary position of a 1^{st} FEC codeword exists in the group. After the de-interleaving position is determined, from the de-interleaving position, the received interleaved data stream may be distributed based on an interleaving granularity and an interleaving depth, and distributed codewords are then combined again in sequence, to obtain the de-interleaved data stream. For example, for the interleaved data stream formed through 4:1 interleaving shown in FIG. 4(a), four FEC codewords are obtained through distribution based on the interleaving granularity, and the four FEC codewords are combined again in a sequence of A, B, C, and D, to obtain a de-interleaved data stream. For the interleaved data stream shown in FIG. 4(b), four FEC codewords are obtained through distribution based on the interleaving granularity, and the four FEC codewords are respectively allocated to four de-interleaved data streams in a sequence of A, B, C, and D.

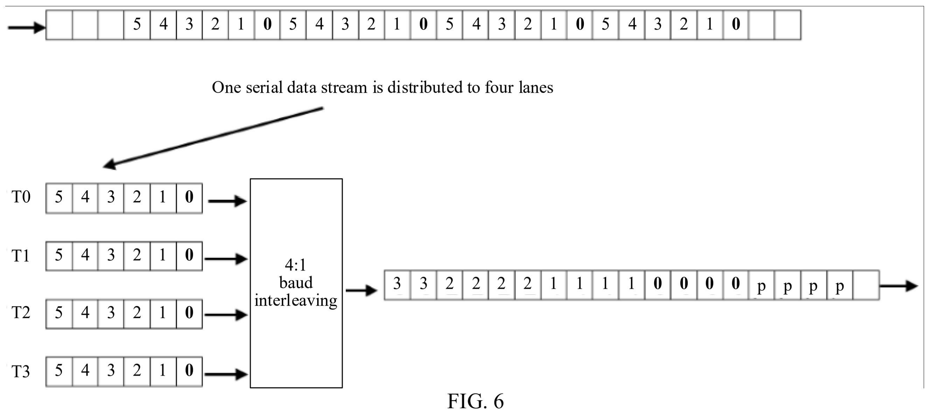

It can be learned that determining a correct de-interleaving position is a prerequisite for the de-interleaving. To determine the de-interleaving position, the data transmitter may periodically insert, before or after the de-interleaving position, fixed data segments known to the data receiver. These fixed data segments are dedicated to searching for the de-interleaving position, so that the data receiver determines the de-interleaving position by searching for these fixed data segments. The fixed data segment may include an alignment marker (alignment marker, AM), a frame alignment word (frame alignment word), pilot data (pilot), or the like. FIG. 6 shows a manner of inserting additional data, where pppp is an inserted fixed data segment. It can be learned that, in this manner, a fixed data segment needs to be additionally transmitted in addition to original data that needs to be transmitted, resulting in higher transmission costs. In addition, under a transmission condition in which a bandwidth or a phase-locked loop frequency is limited, applicability of this manner is greatly reduced.

This application provides a data stream de-interleaving method, namely, a method for restoring a correct data sequence for an interleaved data stream. The method may be performed by a physical layer PHY chip, a forwarding device, or a pluggable module in an Ethernet. The physical layer PHY chip and the pluggable module may be located in a forwarding device or a server. The forwarding device includes but is not limited to an Ethernet switch or a router. The server includes but is not limited to a computing server or a storage server. The pluggable module includes but is not limited to an optical module. According to the method, processing may start at any position of a received data stream, and a correct de-interleaving position is found in a manner of identifying an FEC codeword characteristic or the like, so that a data stream before interleaving at a data transmitter is restored. According to the foregoing method, the de-interleaving can be completed and data can be correctly restored without inserting the additional fixed data segments dedicated to searching for the de-interleaving position. In this way, adding of additional data is avoided, hardware resources are saved, de-interleaving efficiency is improved, transmission costs are reduced, and network efficiency is improved.

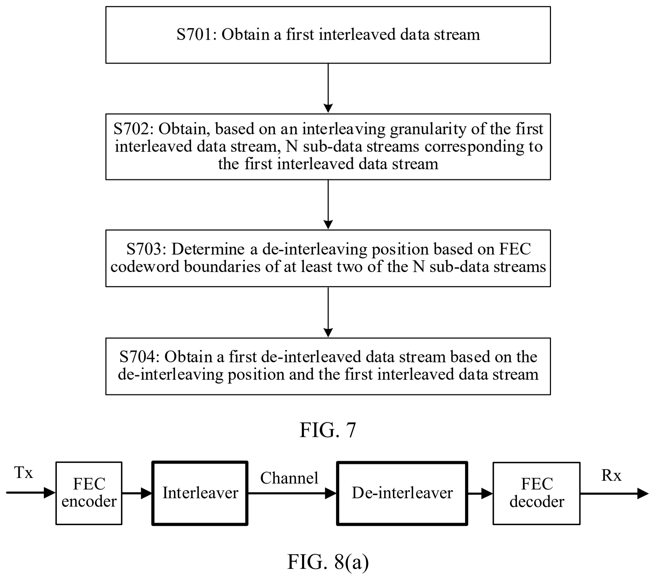

FIG. 7 is a schematic flowchart of a data transmission method 700 according to an embodiment of this application. The method may include the following steps.

Step S701: Obtain a first interleaved data stream.

A data receiver obtains the data stream. The first interleaved data stream is a data stream on which forward error correction FEC encoding is performed. In a possible implementation, an FEC encoding mode of the first interleaved data stream may be FEC encoding of a non-concatenated code, or may be FEC encoding of a concatenated code in the IEEE802.3dj standard.

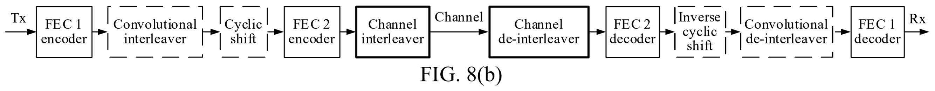

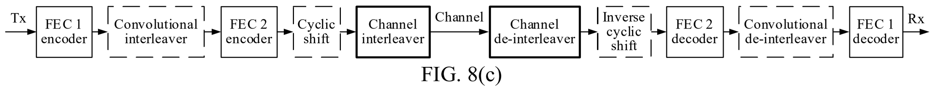

FIG. 8(a), FIG. 8(b), and FIG. 8(c) show application scenarios of a data stream de-interleaving method according to an embodiment of this application. FIG. 8(a) is a non-concatenated code FEC encoding scenario, and FIG. 8(b) and FIG. 8(c) are concatenated code FEC encoding scenarios in the IEEE802.3dj standard. A dashed box is a removable function. For specific content of each function in FIG. 8(b) and FIG. 8(c), refer to the IEEE802.3dj standard. Details are not described herein. A cyclic shift function is introduced to both FIG. 8(b) and FIG. 8(c). A cyclic shift in FIG. 8(b) is performed before second-stage FEC, and a cyclic shift in FIG. 8(c) is performed after the second-stage FEC.

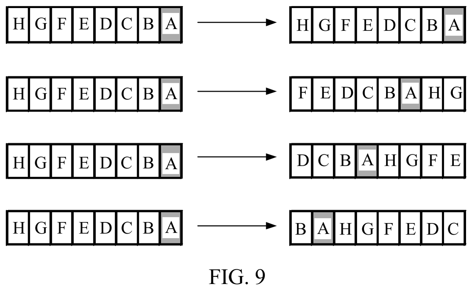

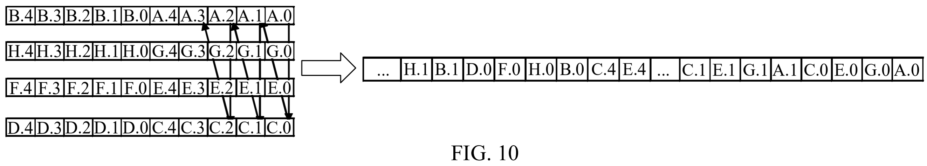

The cyclic shift is a function introduced in the concatenated code FEC encoding scenario. Through the cyclic shift, an internal structure of an inner code FEC codeword of a concatenated code can be disrupted, to further disperse burst errors, reduce impact of the burst errors on outer code FEC of the concatenated code, and enhance error correction performance. A specific function implementation of the cyclic shift is shown in FIG. 9. In FIG. 9, an example in which a channel interleaving depth is 4 is used. For each group of four adjacent inner-code FEC codewords to be interleaved, a cyclic shift with a specified length is performed on bit content in each FEC codeword. Each line is one inner-code FEC codeword, and includes a total of eight symbols A to H. A length of each symbol may be, for example, 10 bits. Symbol blocks such as A, B, C, and D represent symbols from different concatenated outer-code FEC codewords. It can be learned that through the cyclic shift, a structure of an inner-code FEC codeword of an original concatenated code is disrupted, that is, a structure of an FEC codeword including an information bit and a parity bit at an end is disrupted, resulting in a change in an FEC codeword characteristic. FIG. 10 shows a channel interleaving data sequence to which a cyclic shift is added, where each symbol such as A.1 and A.2 may be, for example, a symbol with a 10-bit length.

In a possible implementation, an interleaving type of the first interleaved data stream is symbol interleaving or convolutional interleaving. For specific content of the symbol interleaving or the convolutional interleaving, refer to the foregoing descriptions. Details are not described herein again.

In a possible implementation, the first interleaved data stream does not include a periodic alignment data segment, and the periodic alignment data segment includes an alignment marker (alignment marker), a frame alignment word (frame alignment word), or pilot data (pilot). As described above, according to the data stream de-interleaving method in this embodiment of this application, de-interleaving can be completed at the data receiver and data is correctly restored without inserting, into a data stream at a data transmitter, additional fixed data segments dedicated to determining a de-interleaving position.

In a possible implementation, a lane rate of the first interleaved data stream is greater than or equal to 200 gigabits per second Gbps. The data stream de-interleaving method in this embodiment of this application is applicable to a high-speed Ethernet transmission scenario, for example, an 800 GbE or 1.6 TbE scenario defined in the IEEE standard. For example, the lane rate of the first interleaved data stream may be 200 Gbps, 400 Gbps, 800 Gbps, 1.6 Tbps, or another value.

Step S702: Obtain, based on an interleaving granularity of the first interleaved data stream, N sub-data streams corresponding to the first interleaved data stream. N is an interleaving depth of the first interleaved data stream, and N is a positive integer greater than 1.

After obtaining the first interleaved data stream, the data receiver de-interleaves the first interleaved data stream. In a possible implementation, a processing process of the data receiver may start from any position in the first interleaved data stream. For example, the data receiver randomly selects a start position in the first interleaved data stream, and starts to perform processing.

In embodiments of this application, the data receiver can learn of a parameter in a process in which the data transmitter processes the first interleaved data stream, for example, an FEC codeword length, an interleaving granularity, or an interleaving depth. Based on this, the data receiver de-interleaves the first interleaved data stream.

In a possible implementation, after determining the start position, the data receiver distributes the first interleaved data stream into the N sub-data streams from the start position based on the interleaving granularity of the first interleaved data stream. The start position may also be referred to as a data stream distribution start position. The sub-data stream may also be referred to as a sub-lane data stream.

In a possible implementation, the data receiver distributes data of the first interleaved data stream to the N sub-data streams in a round-robin manner based on the interleaving granularity of the first interleaved data stream.

In a possible implementation, N is 4 or 8.

In a possible implementation, the N sub-data streams are not obtained once based on the distribution. Instead, each time one sub-data stream is obtained from the first interleaved data stream, processing is first performed on the sub-data stream, and then a next sub-data stream is obtained. Such a process is performed for N times, to obtain the N sub-data streams.

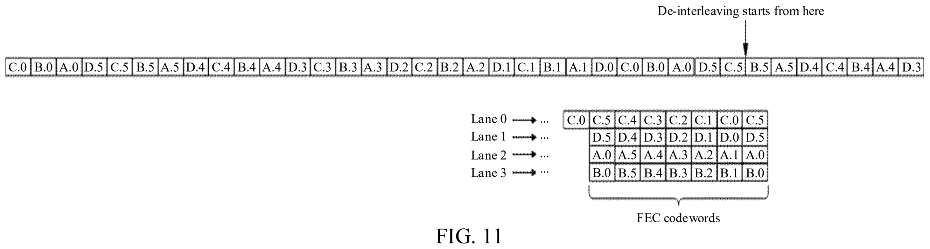

FIG. 11 shows an example of a process of distributing the first interleaved data stream to the N sub-data streams. For example, the interleaving depth N is 4. The data receiver receives the interleaved data stream, where the interleaved data stream includes a plurality of symbols, for example, D.3, A.4, B.4, C.4, ..., A.0, B.0, and C.0 in the figure. The data receiver selects any position from the interleaved data stream, for example, C.5 in FIG. 11, and distributes the interleaved data stream based on an interleaving granularity from the position, to obtain four sub-data streams. In addition, data of the interleaved data stream is distributed to the four sub-data streams in a round-robin manner. To be specific, a lane 0 first obtains a 1^{st} symbol C.5, a lane 1 obtains a 2^{nd} symbol D.5, a lane 2 obtains a 3^{rd} symbol A.0, a lane 3 obtains a 4^{th} symbol B.0, the lane 0 obtains a 5^{th} symbol C.0, and so on. Data at each sub-data stream obtained through distribution is formed by a series of FEC codewords, to determine an FEC codeword boundary of each sub-data stream in a subsequent step.

In a possible implementation, if the cyclic shift shown in FIG. 8(c) exists at a data transmitter, that is, when the cyclic shift at the data transmitter is performed after second-stage FEC, in the N sub-data streams obtained by the data receiver, a data structure of each FEC codeword in each sub-data stream is disrupted, that is, there is a cyclic shift relationship between FEC codewords of the N sub-data streams.

Step S703: Determine a de-interleaving position based on FEC codeword boundaries of at least two of the N sub-data streams.

In a possible implementation, after obtaining the N sub-data streams corresponding to the first interleaved data stream, the data receiver further determines the FEC codeword boundary of each of the N sub-data streams. In embodiments of this application, a specific manner of determining the FEC codeword boundary is not limited. In embodiments of this application, the de-interleaving position is for correctly de-interleaving the data, and restoring original codewords and a relative sequence of the original codewords, to restore a data stream before encoding.

In a possible implementation, the data receiver may determine the FEC codeword boundary of each of the N sub-data streams based on an FEC codeword characteristic. For example, characteristic value verification is performed in the sub-data stream based on an assumed FEC codeword boundary, and the FEC codeword boundary is determined based on a verification result. A characteristic value may be, for example, a syndrome. As shown in FIG. 11, in an example, an FEC codeword boundary of each of the four sub-data streams is a position at which a symbol 0 is located. To be specific, an FEC codeword boundary on the lane 0 is a position shown by the symbol C.0, an FEC codeword boundary on the lane 1 is a position shown by the symbol D.0, an FEC codeword boundary on the lane 2 is a position shown by the symbol A.0, and an FEC codeword boundary on the lane 3 is a position shown by the symbol B.0. It needs to be noted that the FEC codeword boundary of each sub-data stream periodically appears in the data stream, and an interval length between the FEC codeword boundaries is an FEC codeword length.

In embodiments of this application, specific content of the FEC codeword boundary that is in the data stream and that is determined based on the FEC codeword characteristic may be found in the patent file with Application No. 202010424884.9 and filed on May 19, 2020, the patent file with Application No. 202110904102.6 and filed on August 6, 2021, and the patent file with Application No. 202210520888.6 and filed on May 12, 2022, and the foregoing descriptions are incorporated herein by reference in their entireties as if they were all stated.

In a possible implementation, the data receiver may alternatively determine the FEC codeword boundary of each of the N sub-data streams based on other information than an FEC codeword characteristic. The other information includes but is not limited to: scrambling code information, AMs in the N sub-data streams, and the like. The AMs in the N sub-data streams may be, for example, AMs inserted by a physical coding sublayer PCS. The AMs are disrupted after being interleaved with data at the data transmitter. That is, when receiving the interleaved data streams, the data receiver cannot find the AMs, but may restore the AMs from the obtained N sub-data streams, and determine the FEC codeword boundaries of the sub-data streams by using the AMs.

In a possible implementation, the data receiver may first determine an FEC codeword boundary of one of the N sub-data streams based on the FEC codeword characteristic or the other information, and then further determine FEC codeword boundaries of other sub-data streams based on the FEC codeword boundary of the sub-data stream. For example, the data receiver first determines an FEC codeword boundary of any one of the N sub-data streams based on the FEC codeword characteristic or the other information, and then estimates possible positions of the FEC codeword boundaries of the other sub-data streams based on the FEC codeword boundary of the sub-data stream, thereby greatly reducing a computation amount or power consumption needed for finding the codeword boundaries of all the sub-data streams. As shown in FIG. 11, in an example, the data receiver first finds the FEC codeword boundary on the lane 0 in the four sub-data streams, namely, the position shown by the symbol C.0, which may also be referred to as a position 0. Based on an interleaving feature, it can be learned that the FEC codeword boundaries of all the sub-data streams obtained through distribution are distributed in a same column or distributed in two adjacent columns. Therefore, after it is determined that the FEC codeword boundary on the lane 0 is the position 0, the FEC codeword boundaries of the other sub-data streams are definitely also a position 0 or a position adjacent to the position 0, for example, a position 5. The lane 1 is used as an example. The FEC codeword boundary on the lane 1 is definitely at the position shown by D.0 or a position shown by D.5 in the figure. Therefore, for the lane 1, the FEC codeword boundary can be found by verifying only the two positions D.0 or D.5, and other positions such as D.1 to D.4 do not need to be verified, so that a computation amount is greatly reduced. Similarly, for the lane 2, the FEC codeword boundary can be found by verifying only A.1 or A.0, and other positions such as A.2 to A.5 do not need to be verified. For the lane 3, the FEC codeword boundary can be found by verifying only B.1 or B.0, and other positions such as B.2 to B.5 do not need to be verified. It needs to be noted that, the data receiver may first find a position of an FEC codeword boundary on any lane in the four sub-data streams, for example, the FEC codeword boundary on the lane 2, and then determine possible positions of FEC codeword boundaries of other three sub-data streams based on the position, thereby reducing a computation amount or power consumption needed for finding the FEC codeword boundaries of the three sub-data streams. Principles are the same, and details are not described herein again.

In a possible implementation, as described above, if the cyclic shift shown in FIG. 8(c) exists at the data transmitter, that is, when the cyclic shift at the data transmitter is performed after the second-stage FEC, in the N sub-data streams obtained by the data receiver, there is the cyclic shift relationship between the FEC codewords of the N sub-data streams, and the cyclic shift changes the FEC codeword characteristic in the sub-data stream. In this case, before the FEC codeword boundary of each of the N sub-data streams is determined based on the FEC codeword characteristic, an inverse cyclic shift needs to be performed on the FEC codeword of each sub-data stream, to restore a disrupted structure of the FEC codeword. Further, the FEC codeword boundary of each of the N sub-data streams after the inverse cyclic shift may be determined based on the FEC codeword characteristic.

After determining the FEC codeword boundary of each of the N sub-data streams, the data receiver determines the de-interleaving position based on the FEC codeword boundaries of at least two of the N sub-data streams. As described above, after the data receiver obtains the N sub-data streams corresponding to the first interleaved data stream, the N sub-data streams are arranged in sequence. When the de-interleaving position is determined based on the FEC codeword boundaries of the at least two of the N sub-data streams, there may be two cases.

In a first possible case, there is an interval between FEC codeword boundaries of at least two adjacent sub-data streams. For example, the two adjacent sub-data streams may be a first sub-data stream and a second sub-data stream. The data receiver determines, based on the FEC codeword boundary of the first sub-data stream being after the FEC codeword boundary of the second sub-data stream, that the de-interleaving position is the FEC codeword boundary of the second sub-data stream.

In embodiments of this application, a sequence of the FEC codeword boundaries is a sequence of transmitting data at positions of the FEC codeword boundaries of the first interleaved data stream, or is referred to as a fast-slow sequence. When it is found that there is an interval between FEC codeword boundaries of two adjacent sub-data streams, a sub-data stream whose FEC codeword boundary is ahead is a sub-data stream transmitted faster, and the FEC codeword boundary of the sub-data stream transmitted faster is a correct de-interleaving position.

Usually, the first sub-data stream is before the second sub-data stream in an arrangement sequence, and there is an interval of one symbol between the FEC codeword boundaries of the two sub-data streams.

In a second possible case, FEC codeword boundaries of all sub-data streams are aligned. The data receiver determines that an FEC codeword boundary of a sub-data stream that is the first in an arrangement sequence in the N sub-data streams is a correct de-interleaving position. In this case, if a current position at which de-interleaving distribution starts is an FEC codeword boundary, the current position at which the de-interleaving distribution starts is the correct de-interleaving position.

In embodiments of this application, that FEC codeword boundaries of all sub-data streams are aligned means that data at the position of the FEC codeword boundary of each sub-data stream is in data corresponding to one de-interleaving distribution, that is, the data at the position of the FEC codeword boundary of each sub-data stream is in data corresponding to a group of interleaving at the data transmitter.

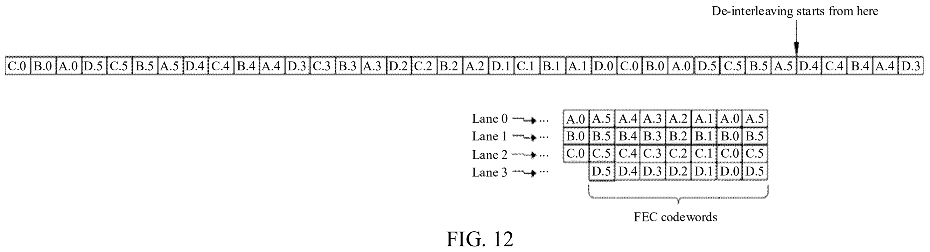

FIG. 11 and FIG. 12 respectively show two possible cases of determining the de-interleaving position based on the FEC codeword boundaries of at least two of the N sub-data streams.

As shown in FIG. 11, as described above, in an example, the FEC codeword boundary of each of the four sub-data streams is the position at which the symbol 0 is located. To be specific, the FEC codeword boundary on the lane 0 is the position shown by the symbol C.0, the FEC codeword boundary on the lane 1 is the position shown by the symbol D.0, the FEC codeword boundary on the lane 2 is the position shown by the symbol A.0, and the FEC codeword boundary on the lane 3 is the position shown by the symbol B.0. It can be learned through comparison between the FEC codeword boundaries of the four sub-data streams that, the FEC codeword boundaries of at least two of the four sub-data streams are not in the same column, that is, are not aligned. As shown in FIG. 11, there is an interval between the FEC codeword boundaries on the lane 1 and the lane 2. The FEC codeword boundary on the lane 1 is D.0, the FEC codeword boundary on the lane 2 is A.0, and the FEC codeword boundary on the lane 1 is located after the FEC codeword boundary on the lane 2. Therefore, the FEC codeword boundary A.0 on the lane 2 is a correct de-interleaving position.

FIG. 12 shows an example of another process of distributing the first interleaved data stream to the N sub-data streams. For example, an interleaving depth N is 4. Different from FIG. 11, a data receiver selects any position from the received interleaved data stream, for example, A.5 in FIG. 12, and distributes the interleaved data stream based on an interleaving granularity from the position, to obtain four sub-data streams. In addition, data of the interleaved data stream is distributed to the four sub-data streams in a round-robin manner. To be specific, a 1^{st} symbol A.5 is first obtained on a lane 0, a 2^{nd} symbol B.5 is obtained on a lane 1, a 3^{rd} symbol C.5 is obtained on a lane 2, a 4^{th} symbol D.5 is obtained on a lane 3, a 5^{th} symbol A.0 is obtained on the lane 0, and so on. An FEC codeword boundary of each of the four sub-data streams is a position at which a symbol 0 is located. To be specific, an FEC codeword boundary on the lane 0 is a position shown by the symbol A.0, an FEC codeword boundary on the lane 1 is a position shown by a symbol B.0, an FEC codeword boundary on the lane 2 is a position shown by a symbol C.0, and an FEC codeword boundary on the lane 3 is a position shown by a symbol D.0. It can be learned through comparison between the FEC codeword boundaries of the four sub-data streams that, the FEC codeword boundaries of the four sub-data streams are in the same column, that is, are aligned. In this case, considering that the lane 0 is the first in an arrangement sequence of the four sub-data streams, the FEC codeword boundary A.0 on the lane 0 is a de-interleaving position.

It can be learned through comparison between FIG. 11 and FIG. 12 that, the data transmitter interleaves a plurality of FEC codewords whose FEC codeword boundaries are aligned. When the data receiver performs de-interleaving by using any randomly selected position as a start position, FEC codeword boundaries of a plurality of obtained sub-data streams may be aligned or may not be aligned. However, even if the FEC codeword boundaries of the plurality of sub-data streams are not aligned, the codeword boundaries are still adjacent at an interval of only one symbol. In addition, it needs to be noted that, if it is determined that the FEC codeword boundaries of the plurality of sub-data streams are not adjacent and are at an interval of more than two symbols, it indicates that an error occurs in the foregoing steps, which may be an error in the process of determining the FEC codeword boundaries of the sub-data streams, or may be an error in other processes. In this case, return to step S702, to re-determine a start position, and obtain N sub-data streams from the first interleaved data stream.

Step S704: Obtain a first de-interleaved data stream based on the de-interleaving position and the first interleaved data stream.

After determining the de-interleaving position, the data receiver may combine the FEC codewords in the first interleaved data stream to obtain the de-interleaved data stream, and restore data before the interleaving.

In a possible implementation, in addition to determining the FEC codeword boundary of each of the N sub-data streams, the data receiver further needs to determine a de-interleaving and combination sequence of the N sub-data streams, and further combines the FEC codewords of the N sub-data streams based on the de-interleaving and combination sequence, to obtain the first de-interleaved data stream.

In a possible implementation, when determining a de-interleaving and combination sequence of the N sub-data streams, the data receiver determines the de-interleaving and combination sequence of the N sub-data streams based on a distribution sequence of distributing the first interleaved data stream to the N sub-data streams and a position relationship between the FEC codeword boundaries of all of the N sub-data streams. The position relationship is determined based on a sequence of data at positions of the FEC codeword boundaries of all of the N sub-data streams in the first interleaved data stream. It is easy to understand that a sequence of the data of the first interleaved data stream is a sequence of receiving the data, that is, in the first interleaved data stream, the data that is received first is before the data that is received later.

In a possible implementation, when obtaining the first de-interleaved data stream based on the first interleaved data stream, the data receiver does not require that all data of the first interleaved data stream be in the first de-interleaved data stream. In an example, some data of the first interleaved data stream is in the first de-interleaved data stream.

In a possible implementation, the data used to obtain the first de-interleaved data stream through combination may be some data of the first interleaved data stream, or some data of the first interleaved data stream is not combined into the de-interleaved data stream. For example, the data used to obtain the de-interleaved data stream through combination and the data that is distributed to the N sub-data streams and that is used to determine the de-interleaving position may be different data of the first interleaved data stream. For example, the data that is distributed to the N sub-data streams and that is used to determine the de-interleaving position may be discarded after the de-interleaving position is found, and is not introduced into the de-interleaved data stream. For example, the data used to obtain the de-interleaved data stream through combination may be data that is in the first interleaved data stream and that is located after the data distributed to the N sub-data streams.

In embodiments of this application, a specific manner of obtaining the de-interleaved data stream after the de-interleaving position is found is not limited. In a possible implementation, after the de-interleaving position is found, the interleaved data stream may not be distributed to the N sub-data streams any more, but the de-interleaved data stream is obtained based on the de-interleaving position and the interleaved data stream.

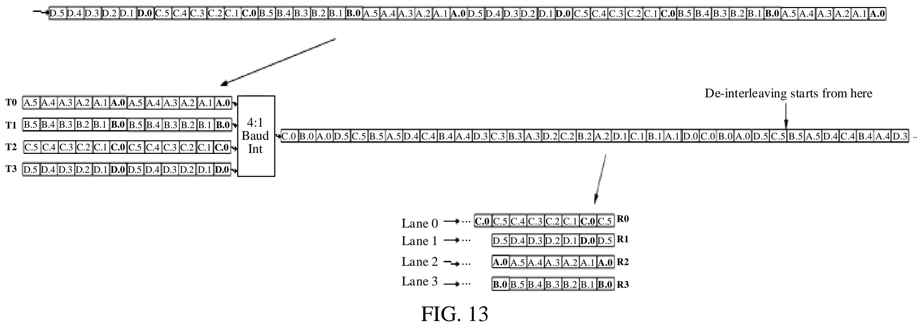

FIG. 13 shows an example of a data stream de-interleaving method according to an embodiment of this application. As shown in FIG. 13, a data transmitter obtains a single to-be-interleaved data stream. The to-be-interleaved data stream includes a plurality of FEC codewords, each codeword includes 12 bits, and every two adjacent bits are one PAM4 symbol, for example, A.0, and A.1 in FIG. 13. The data transmitter interleaves the data stream, distributes the data stream to four sub-data streams: T0, T1, T2, and T3 in FIG. 13, and then performs interleaving based on the PAM4 symbol to obtain an interleaved data stream. After obtaining the interleaved data stream, a data receiver selects any position from the interleaved data stream, for example, C.5 in FIG. 13, and from the position, performs PAM4 symbol de-interleaving on the interleaved data stream based on an interleaving granularity for distribution, to obtain four sub-data streams: a lane 0, a lane 1, a lane 2, and a lane 3. It is determined based on an FEC codeword characteristic that an FEC codeword boundary of each of the four sub-data streams is a position at which a symbol 0 is located. Further, through comparison between FEC codeword boundaries of the four sub-data streams, and considering a relationship between positions of the FEC codeword boundaries of all of the four sub-data streams and a distribution sequence of the four sub-data streams, an arrangement sequence of the four sub-data streams is determined as the lane 2, the lane 3, the lane 0, the lane 1, and an FEC codeword boundary A.0 of the lane 2 is a de-interleaving position. FEC codewords of the four sub-data streams are combined based on the sequence. For example, FEC codewords A.0 to A.5 are obtained from the lane 2, FEC codewords B.0 to B.5 are obtained from the lane 3, FEC codewords C.0 to C.5 are obtained from the lane 0, and FEC codewords D.0 to D.5 are obtained from the lane 1; and a group of de-interleaved data may be obtained through combination based on the sequence. The rest may be deduced by analogy, to obtain more groups of de-interleaved data. It can be learned that the data after the de-interleaving is the same as data before the interleaving at the data transmitter.

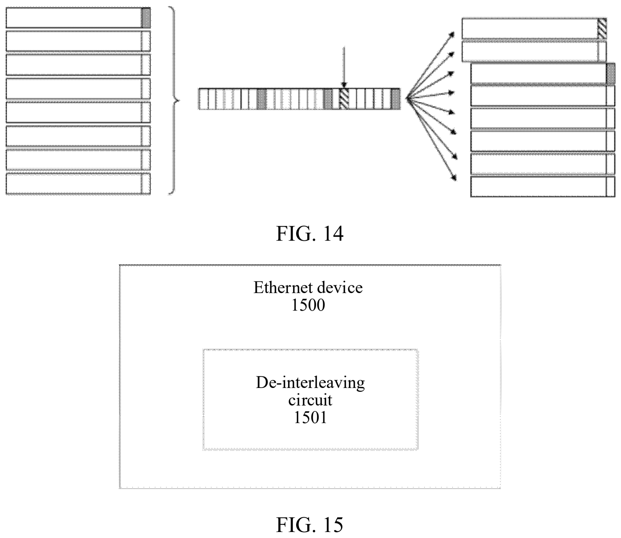

FIG. 14 shows another example of a data stream de-interleaving method according to an embodiment of this application. For example, a quantity of sub-data streams is 8, each small square represents one PAM4 symbol, and a small gray square is a 1^{st} FEC codeword in a group of interleaving, namely, a correct de-interleaving position. As shown in FIG. 14, a data transmitter interleaves eight sub-data streams, to obtain an interleaved data stream, and sends the interleaved data stream to a data receiver. The data receiver receives the interleaved data stream, and starts processing from any position, for example, a small square filled with slashes shown in FIG. 14. An FEC codeword boundary of each sub-data stream is determined based on an FEC codeword characteristic. When an interval between FEC codeword boundaries of two adjacent sub-data streams is one PAM4 symbol, as shown in FIG. 14, an interval between FEC codeword boundaries of a 2^{nd} sub-data stream and a 3^{rd} sub-data stream is one PAM4 symbol, and the FEC codeword boundary of the 3^{rd} sub-data stream is more ahead, that is, the 3^{rd} sub-data stream is a sub-data stream transmitted faster in the interleaved data stream, the FEC codeword boundary of the 3^{rd} sub-data stream is a correct de-interleaving position (a small gray square position in the 3^{rd} sub-data stream shown in FIG. 14). It is easy to understand that, if there is no interval between FEC codeword boundaries of the sub-data streams in the eight sub-data streams, the foregoing any position is the correct de-interleaving position.

According to the foregoing method, the de-interleaving can be completed and data can be correctly restored without inserting additional fixed data segments. In this way, adding of additional data is avoided, transmission costs are reduced, and network efficiency is improved.

FIG. 15 is a diagram of a structure of an Ethernet device according to an embodiment of this application. The Ethernet device may be configured to receive data, and the Ethernet device may be the Ethernet device in the data stream de-interleaving method shown in FIG. 7. Based on the structure shown in FIG. 15, the Ethernet device 1500 can perform all or some operations in the method shown in FIG. 7. It should be understood that the Ethernet device may include more additional structures than the shown structure, or a part of the shown structure is omitted. This is not limited in this embodiment of this application. As shown in FIG. 15, the Ethernet device includes:
a de-interleaving circuit 1501, configured to: obtain a first interleaved data stream, where the first interleaved data stream is a data stream on which forward error correction FEC encoding is performed; obtain, based on an interleaving granularity of the first interleaved data stream, N sub-data streams corresponding to the first interleaved data stream, where N is an interleaving depth of the first interleaved data stream, and N is a positive integer greater than 1; determine a de-interleaving position based on FEC codeword boundaries of at least two of the N sub-data streams; and obtain a first de-interleaved data stream based on the de-interleaving position and the first interleaved data stream.

In a possible implementation, the Ethernet device may further include an interface circuit. The interface circuit may be configured to receive the first interleaved data stream. The interface circuit may be further configured to send the first de-interleaved data stream.

In a possible implementation, the N sub-data streams are arranged in sequence, and the determining a de-interleaving position based on FEC codeword boundaries of at least two of the N sub-data streams includes: determining, based on an FEC codeword boundary of a first sub-data stream being after an FEC codeword boundary of a second sub-data stream, that the de-interleaving position is the FEC codeword boundary of the second sub-data stream, where the first sub-data stream and the second sub-data stream are two adjacent sub-data streams in the N sub-data streams.

In a possible implementation, the first sub-data stream is before the second sub-data stream in an arrangement sequence.

In a possible implementation, there is an interval of one symbol between the FEC codeword boundary of the first sub-data stream and the FEC codeword boundary of the second sub-data stream.

In a possible implementation, the N sub-data streams are arranged in sequence, and the determining a de-interleaving position based on FEC codeword boundaries of at least two of the N sub-data streams includes: determining, based on alignment of FEC codeword boundaries of all of the N sub-data streams, that the de-interleaving position is an FEC codeword boundary of a first sub-data stream, where the first sub-data stream has a highest ranking in the N sub-data streams in an arrangement sequence.

In a possible implementation, the N sub-data streams are arranged in sequence, and the obtaining a first de-interleaved data stream based on the de-interleaving position and the first interleaved data stream includes: determining a de-interleaving and combination sequence of the N sub-data streams based on the de-interleaving position and the arrangement sequence of the N sub-data streams; and combining data of the first interleaved data stream based on the de-interleaving and combination sequence, to obtain the first de-interleaved data stream.

In a possible implementation, the obtaining, based on an interleaving granularity of the first interleaved data stream, N sub-data streams corresponding to the first interleaved data stream includes: selecting a data stream distribution start position from the first interleaved data stream, and distributing the first interleaved data stream to the N sub-data streams based on the interleaving granularity of the first interleaved data stream, where the data stream distribution start position is a position randomly selected from the first interleaved data stream.

In a possible implementation, the obtaining, based on an interleaving granularity of the first interleaved data stream, N sub-data streams corresponding to the first interleaved data stream includes: distributing the data of the first interleaved data stream to the N sub-data streams in a round-robin manner based on the interleaving granularity of the first interleaved data stream.

In a possible implementation, the de-interleaving circuit is further configured to determine an FEC codeword boundary of each of the N sub-data streams.

In a possible implementation, the determining an FEC codeword boundary of each of the N sub-data streams includes: determining the FEC codeword boundary of each of the N sub-data streams based on an FEC codeword characteristic.

In a possible implementation, the determining the FEC codeword boundary of each of the N sub-data streams based on an FEC codeword characteristic includes: in each sub-data stream, separately performing characteristic value verification based on an assumed FEC codeword boundary, and determining the FEC codeword boundary of each sub-data stream based on a verification result.

In a possible implementation, there is a cyclic shift relationship between FEC codewords of the N sub-data streams, and the determining the FEC codeword boundary of each of the N sub-data streams based on an FEC codeword characteristic includes: performing an inverse cyclic shift on the obtained FEC codewords of the N sub-data streams; and determining the FEC codeword boundary of each of the N sub-data streams after the inverse cyclic shift based on the FEC codeword characteristic.

In a possible implementation, the first interleaved data stream does not include a periodic alignment data segment, and the periodic alignment data segment includes an alignment marker, a frame alignment word, or pilot data.

In a possible implementation, an FEC encoding mode of the first interleaved data stream is FEC encoding of a non-concatenated code or FEC encoding of a concatenated code.

In a possible implementation, N is 4 or 8.

In a possible implementation, an interleaving type of the first interleaved data stream is symbol interleaving or convolutional interleaving.

In a possible implementation, the method is performed by a physical layer PHY chip, a forwarding device, or a pluggable module.

In a possible implementation, a lane rate of the first interleaved data stream is greater than or equal to 200 gigabits per second Gbps.

For specific descriptions of operations performed by the Ethernet device, refer to specific descriptions of the method embodiment shown in FIG. 7. Details are not described herein again.

The Ethernet device may be a physical layer PHY chip, a forwarding device, or a pluggable module. The forwarding device may be an Ethernet forwarding device such as a switch or a router, and the pluggable module is not limited to a pluggable optical module or electrical module.

When the Ethernet device is the Ethernet forwarding device such as the switch or the router, the Ethernet device may include an Ethernet chip, or a pluggable optical module or electrical module. The Ethernet chip, or the pluggable optical module or electrical module can perform all or some operations in the method in FIG. 7.

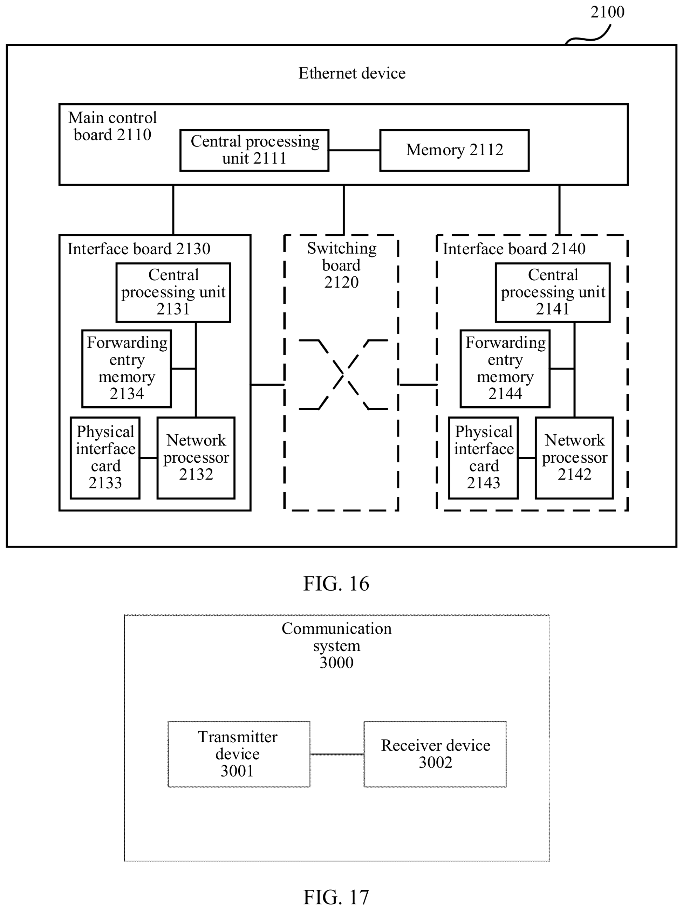

FIG. 16 is a diagram of a structure of an Ethernet device 2100 according to another example embodiment of this application. The Ethernet device 2100 shown in FIG. 16 is configured to perform all or some operations related to the data stream de-interleaving method shown in FIG. 7. The network device 2100 is, for example, a physical layer PHY chip, a forwarding device, or a pluggable module. The Ethernet device 2100 may be implemented by using a general bus architecture.

As shown in FIG. 16, the Ethernet device 2100 includes a main control board 2110 and an interface board 2130.

The main control board is also referred to as a main processing unit (main processing unit, MPU) or a route processor card (route processor card). The main control board 2110 is configured to: control and manage components in the Ethernet device 2100, including functions of route calculation, device management, device maintenance, and protocol processing. The main control board 2110 includes a central processing unit 2111 and a memory 2112.

The interface board 2130 is also referred to as a line interface unit (line processing unit, LPU), a line card (line card), or a service board. The interface board 2130 is configured to: provide various service interfaces and implement data packet forwarding. The service interfaces include but are not limited to an Ethernet interface, a POS (Packet over SONET/SDH) interface, and the like. The Ethernet interface is, for example, a flexible Ethernet service interface (Flexible Ethernet Clients, FlexE Clients). The interface board 2130 includes a central processing unit 2131, a network processor 2132, a forwarding entry memory 2134, and a physical interface card (physical interface card, PIC) 2133.

The central processing unit 2131 on the interface board 2130 is configured to: control and manage the interface board 2130 and communicate with the central processing unit 2111 on the main control board 2110.

The network processor 2132 is configured to implement packet forwarding processing. A form of the network processor 2132 may be a forwarding chip. The forwarding chip may be a network processor (network processor, NP). In some embodiments, the forwarding chip may be implemented by using an application-specific integrated circuit (application-specific integrated circuit, ASIC) or a field programmable gate array (field programmable gate array, FPGA). Specifically, the network processor 2132 is configured to: forward a received packet based on a forwarding table stored in the forwarding entry memory 2134. If a destination address of the packet is an address of the Ethernet device 2100, the network processor sends the packet to a CPU (for example, the central processing unit 2131) for processing. If a destination address of the packet is not an address of the Ethernet device 2100, the network processor searches, based on the destination address, the forwarding table for a next hop and an outbound interface corresponding to the destination address, and forwards the packet to the outbound interface corresponding to the destination address. Processing of an uplink packet may include: processing of an inbound interface of the packet and forwarding table lookup; and processing of a downlink packet may include: forwarding table lookup and the like. In some embodiments, the central processing unit may alternatively perform a function of the forwarding chip, for example, implement software forwarding based on a general-purpose CPU. Therefore, the forwarding chip is not needed in the interface board.

The physical interface card 2133 is configured to implement a physical layer interconnection function, so that original traffic enters the interface board 2130 from the physical interface card, and a processed packet is sent out from the physical interface card 2133. The physical interface card 2133 is also referred to as a subcard, may be installed on the interface board 2130, and is responsible for converting an optical/electrical signal into a packet, performing validity check on the packet, and then forwarding the packet to the network processor 2132 for processing. In some embodiments, the central processing unit 2131 may alternatively perform a function of the network processor 2132, for example, implement software forwarding based on a general-purpose CPU. Therefore, the network processor 2132 is not needed in the physical interface card 2133.

Optionally, the Ethernet device 2100 includes a plurality of interface boards. For example, the Ethernet device 2100 further includes an interface board 2140. The interface board 2140 includes: a central processing unit 2141, a network processor 2142, a forwarding entry memory 2144, and a physical interface card 2143. Functions and implementations of components in the interface board 2140 are the same as or similar to those of the interface board 2130. Details are not described herein again.

Optionally, the Ethernet device 2100 further includes a switching board 2120. The switching board 2120 may also be referred to as a switch fabric unit (switch fabric unit, SFU). When the network device 2100 has the plurality of interface boards, the switching board 2120 is configured to perform data exchange between the interface boards. For example, the interface board 2130 and the interface board 2140 may communicate with each other by using the switching board 2120.

The main control board 2110 is coupled to the interface board. For example, the main control board 2110, the interface board 2130, the interface board 2140, and the switching board 2120 are connected to a system backboard by using a system bus to implement interworking. In a possible implementation, an inter-process communication (inter-process communication, IPC) protocol lane is established between the main control board 2110, the interface board 2130, and the interface board 2140, and the main control board 2110, the interface board 2130, and the interface board 2140 communicate with each other through the IPC lane.

Logically, the Ethernet device 2100 includes a control plane and a forwarding plane. The control plane includes the main control board 2110 and the central processing unit 2111. The forwarding plane includes components that perform forwarding, such as the forwarding entry memory 2134, the physical interface card 2133, and the network processor 2132. The control plane performs functions such as a function of a router, a function of generating a forwarding table, a function of processing signaling and protocol packets, and a function of configuring and maintaining a state of the network device. The control plane delivers the generated forwarding table to the forwarding plane. On the forwarding plane, the network processor 2132 searches, based on the forwarding table delivered by the control plane, a table for forwarding the packet received by the physical interface card 2133. The forwarding table delivered by the control plane may be stored in the forwarding entry memory 2134. In some embodiments, the control plane and the forwarding plane may be completely separated, and are not on a same network device.

It should be noted that there may be one or more main control boards, and when there are a plurality of main control boards, a primary main control board and a secondary main control board may be included. There may be one or more interface boards. A network device with a stronger data processing capability provides a larger quantity of interface boards. There may also be one or more physical interface cards on the interface board. There may be no switching board or one or more switching boards. When there are a plurality of switching boards, load balancing and redundancy backup may be implemented together. In a centralized forwarding architecture, the network device may not need a switching board, and the interface board provides a function of processing service data of an entire system. In a distributed forwarding architecture, the network device may have at least one switching board, and data exchange between a plurality of interface boards is implemented by using the switching board, to provide a large-capacity data exchange and processing capability. Therefore, a data access and processing capability of the network device in the distributed architecture is greater than that of the network device in the centralized architecture. Optionally, a form of the network device may alternatively be a single board. To be specific, there is no switching board, and functions of the interface board and the main control board are integrated into the board. In this case, the central processing unit on the interface board and the central processing unit on the main control board may be combined into one central processing unit on the board, to perform functions obtained by combining the two central processing units. The network device in this form (for example, a network device such as a low-end switch or router) has a low data exchange and processing capability. A specific architecture that is to be used depends on a specific networking deployment scenario. This is not limited herein.

In a specific embodiment, the Ethernet device 2100 corresponds to the Ethernet device shown in FIG. 15.

For example, the Ethernet device 2100 may be the Ethernet device shown in FIG. 15, which is an Ethernet forwarding device such as a switch or a router. In this case, an Ethernet chip that performs the method shown in FIG. 7 may be located in the main control board 2110, or may be located in the interface board 2130 or the interface board 2140, and the Ethernet chip may be specifically located in the physical interface card 2133 or 2143.

As shown in FIG. 17, an embodiment of this application further provides a communication system 3000. A packet processing system includes a transmitter device 3001 and a receiver device 3002. Optionally, the receiver device 3002 performs the data stream de-interleaving method shown in FIG. 7.

An embodiment of this application further provides a computer-readable storage medium. The storage medium stores at least one instruction, and the instruction is loaded and executed by a processor, to enable a computer to implement any one of the foregoing data sending method or the foregoing data receiving method.

An embodiment of this application further provides a computer program (product). When the computer program is executed by a computer, a processor or the computer may be enabled to perform corresponding steps and/or procedures in the foregoing method embodiments.

An embodiment of this application further provides a chip, including: a processor, configured to: invoke, from a memory, instructions stored in the memory and run the instructions, to enable a communication device in which the chip is installed to perform any one of the foregoing data sending method or the foregoing data receiving method.

An embodiment of this application further provides another chip, including an input interface, an output interface, a processor, and a memory. The input interface, the output interface, the processor, and the memory are connected through an internal connection path. The processor is configured to execute code in the memory. When the code is executed, the processor is configured to perform any one of the foregoing data sending method or the foregoing data receiving method.

All or some of the foregoing embodiments may be implemented by software, hardware, firmware, or any combination thereof. When software is used to implement embodiments, all or some of embodiments may be implemented in a form of a computer program product. The computer program product includes one or more computer instructions. When computer program instructions are loaded and executed on a computer, the procedure or functions according to this application are completely or partially generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line) or wireless (for example, infrared, radio, or microwave) manner. The computer-readable storage medium may be any usable medium accessible by the computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid-state disk (solid-state disk)), or the like.

Persons of ordinary skill in the art may be aware that, method steps and modules described with reference to embodiments disclosed in this specification can be implemented by using software, hardware, firmware, or any combination thereof. To clearly describe interchangeability between the hardware and the software, steps and compositions of embodiments have been generally described in terms of functions in the foregoing descriptions. Whether the functions are performed by hardware or software depends on particular applications and design constraint conditions of the technical solutions. Persons of ordinary skill in the art may use different methods to implement the described functions for each particular application, but it should not be considered that the implementation goes beyond the scope of this application.

Persons of ordinary skill in the art may understand that all or some of the steps of embodiments may be implemented by hardware or a program instructing related hardware. The program may be stored in a computer-readable storage medium. The storage medium may be a read-only memory, a magnetic disk, or an optical disc.

When software is used to implement embodiments, all or some of embodiments may be implemented in a form of a computer program product. The computer program product includes one or more computer program instructions. In an example, the method according to embodiments of this application may be described in a context of machine-executable instructions. For example, the machine-executable instructions are included in a program module that is in a device for execution on a real or virtual processor of a target. Usually, the program module includes a routine, a program, a library, an object, a class, a component, a data structure, and the like, and executes a specific task or implements a specific abstract data structure. In various embodiments, functions of the program modules may be combined or split between the described program modules. The machine-executable instructions for the program module may be executed locally or within a distributed device. In the distributed device, the program module may be located in both a local storage medium and a remote storage medium.

Computer program code for implementing the method in embodiments of this application may be written in one or more programming languages. The computer program code may be provided for a processor of a general-purpose computer, a dedicated computer, or another programmable data processing apparatus, so that when the program code is executed by the computer or the another programmable data processing apparatus, functions/operations specified in the flowcharts and/or block diagrams are implemented. The program code may be executed completely on the computer, partially on the computer, as an independent software package, partially on the computer and partially on a remote computer, or completely on the remote computer or server.

In the context of embodiments of this application, the computer program code or related data may be carried in any appropriate carrier, so that the device, the apparatus, or the processor can perform various processing and operations described above. Examples of the carrier include a signal, a computer-readable medium, and the like.

Examples of the signal may include an electrical signal, an optical signal, a radio signal, a voice signal, or other forms of propagated signals, such as a carrier wave and an infrared signal.

A machine-readable medium may be any tangible medium that includes or stores programs used for or related to an instruction execution system, apparatus, or device. The machine-readable medium may be a machine-readable signal medium or a machine-readable storage medium. The machine-readable medium may include but is not limited to an electronic, magnetic, optical, electromagnetic, infrared, or semiconductor system, apparatus, or device, or any appropriate combination thereof. A more detailed example of the machine-readable storage medium includes an electrical connection with one or more wires, a portable computer disk, a hard disk, a random access memory (RAM), a read-only memory (ROM), an erasable programmable read-only memory (EPROM or flash memory), an optical storage device, a magnetic storage device, or any appropriate combination thereof.

It may be clearly understood by persons skilled in the art that, for the purpose of convenient and brief description, for a detailed working process of the foregoing system, device, and module, refer to a corresponding process in the foregoing method embodiments. Details are not described herein again.

In the several embodiments provided in this application, it should be understood that the disclosed system, device, and method may be implemented in other manners. For example, the described device embodiment is merely an example. For example, division into modules is merely division into logical functions and there may be other division modes during actual application. For example, a plurality of modules or components may be combined or may be integrated to another system, or some features may be ignored or not executed. In addition, the displayed or discussed mutual couplings or direct couplings or communication connections may be indirect couplings or communication connections implemented through some interfaces, devices, or modules, or may be electrical, mechanical, or other forms of connections.

The modules described as separate components may or may not be physically separate, and components displayed as modules may or may not be physical modules, may be located in one position, or may be distributed on a plurality of network modules. Some or all of the modules may be selected based on an actual requirement to implement the objectives of the solutions of embodiments of this application.

In addition, functional modules in embodiments of this application may be integrated into one processing module, or each of the modules may exist alone physically, or two or more modules may be integrated into one module. The integrated module may be implemented in a form of hardware, or may be implemented in a form of a software functional module.

If the integrated module is implemented in the form of the software functional module and sold or used as an independent product, the integrated module may be stored in a computer-readable storage medium. Based on this understanding, the technical solutions of this application essentially, or the part contributing to a conventional technology, or all or some of the technical solutions may be implemented in a form of a software product. The computer software product is stored in a storage medium, and includes several instructions for instructing a computer device (which may be a personal computer, a server, or a network device) to perform all or some of the steps of the method described in embodiments of this application. The foregoing storage medium includes any medium that can store program code, such as a USB flash drive, a removable hard disk, a read-only memory (read-only memory, ROM), a random access memory (random access memory, RAM), a magnetic disk, or an optical disc.

The terms such as "first" and "second" in this application are used to distinguish between same or similar items with basically same roles and functions. It should be understood that there is no logical or timing dependency between "first", "second", and "n^{th}", and neither a quantity nor an execution sequence is limited. It should be further understood that although the terms such as "first" and "second" are used in the following descriptions to describe various elements, these elements should not be limited by the terms. These terms are simply used to distinguish one element from another. For example, without departing from the scope of various examples, a first image may be referred to as a second image, and similarly, the second image may be referred to as the first image. Both the first image and the second image may be images, and in some cases may be separate and different images.

It should be further understood that sequence numbers of processes do not mean execution sequences in embodiments of this application. The execution sequences of the processes should be determined based on functions and internal logic of the processes, and should not be construed as any limitation on the implementation processes of embodiments of this application.

In this application, the term "at least one" means one or more, and the term "a plurality of" in this application means two or more. For example, a plurality of second packets means two or more second packets. The terms "system" and "network" are often used interchangeably in this specification.

It should be understood that the terms used in the descriptions of the various examples herein are merely intended to describe specific examples and are not intended to impose a limitation. The terms "one" ("a" and "an") and "the" of singular forms used in the descriptions of the various examples and the appended claims are also intended to include plural forms, unless otherwise specified in the context clearly.

It should be further understood that the term "and/or" used in this specification indicates and includes any or all possible combinations of one or more of the associated listed items. The term "and/or" describes an association relationship between associated objects and represents that three relationships may exist. For example, A and/or B may represent the following three cases: Only A exists, both A and B exist, and only B exists. In addition, the character "/" in this application usually indicates an "or" relationship between the associated objects.

It should be further understood that the term "include" (also referred to as "includes", "including", "comprises", and/or "comprising") used in this specification specifies presence of the stated features, integers, steps, operations, elements, and/or components, with presence or addition of one or more other features, integers, steps, operations, elements, components, and/or components thereof not excluded.

It should be further understood that the terms "if" and "assuming that" may be interpreted to mean "when" ("when" or "upon") or "in response to determining" or "in response to detecting". Similarly, according to the context, the phrase "if it is determined that" or "if [a stated condition or event] is detected" may be interpreted as a meaning of "when it is determined that", "in response to determining", "when [the stated condition or event] is detected", or "in response to detecting [the stated condition or event]".

It should be understood that determining B based on A does not mean that B is determined based only on A, and B may alternatively be determined based on A and/or other information.

It should be further understood that "one embodiment", "an embodiment", and "a possible implementation" mentioned throughout the specification mean that a specific feature, structure, or characteristic related to the embodiment or an implementation is included in at least one embodiment of this application. Therefore, "in one embodiment" or "in an embodiment" or "a possible implementation" appearing throughout the specification may not necessarily refer to a same embodiment. In addition, these particular features, structures, or characteristics may be combined in one or more embodiments in any appropriate manner.

The foregoing descriptions are merely optional embodiments of this application, but are not intended to limit this application. Any modification, equivalent replacement, or improvement made without departing from the principle of this application should fall within the protection scope of this application.

## Claims

1. A data stream de-interleaving method, wherein the method comprises:
obtaining a first interleaved data stream, wherein the first interleaved data stream is a data stream on which forward error correction FEC encoding is performed;
obtaining, based on an interleaving granularity of the first interleaved data stream, N sub-data streams corresponding to the first interleaved data stream, wherein N is an interleaving depth of the first interleaved data stream, and N is a positive integer greater than 1;
determining a de-interleaving position based on FEC codeword boundaries of at least two of the N sub-data streams; and
obtaining a first de-interleaved data stream based on the de-interleaving position and the first interleaved data stream.

2. The method according to claim 1, wherein the N sub-data streams are arranged in sequence, and the determining a de-interleaving position based on FEC codeword boundaries of at least two of the N sub-data streams comprises:
determining, based on an FEC codeword boundary of a first sub-data stream being after an FEC codeword boundary of a second sub-data stream, that the de-interleaving position is the FEC codeword boundary of the second sub-data stream, wherein
the first sub-data stream and the second sub-data stream are two adjacent sub-data streams in the N sub-data streams.

3. The method according to claim 2, wherein the first sub-data stream is before the second sub-data stream in an arrangement sequence.

4. The method according to claim 2 or 3, wherein there is an interval of one symbol between the FEC codeword boundary of the first sub-data stream and the FEC codeword boundary of the second sub-data stream.

5. The method according to claim 1, wherein the N sub-data streams are arranged in sequence, and the determining a de-interleaving position based on FEC codeword boundaries of at least two of the N sub-data streams comprises:
determining, based on alignment of FEC codeword boundaries of all of the N sub-data streams, that the de-interleaving position is an FEC codeword boundary of a first sub-data stream, wherein
the first sub-data stream has a highest ranking in the N sub-data streams in an arrangement sequence.

6. The method according to any one of claims 1 to 5, wherein the N sub-data streams are arranged in sequence, and the obtaining a first de-interleaved data stream based on the de-interleaving position and the first interleaved data stream comprises:
determining a de-interleaving and combination sequence of the N sub-data streams based on the de-interleaving position and the arrangement sequence of the N sub-data streams; and
combining data of the first interleaved data stream based on the de-interleaving and combination sequence, to obtain the first de-interleaved data stream.

7. The method according to any one of claims 1 to 6, wherein the obtaining, based on an interleaving granularity of the first interleaved data stream, N sub-data streams corresponding to the first interleaved data stream comprises:
selecting a data stream distribution start position from the first interleaved data stream, and distributing the first interleaved data stream to the N sub-data streams based on the interleaving granularity of the first interleaved data stream, wherein
the data stream distribution start position is a position randomly selected from the first interleaved data stream.

8. The method according to any one of claims 1 to 7, wherein the obtaining, based on an interleaving granularity of the first interleaved data stream, N sub-data streams corresponding to the first interleaved data stream comprises:
distributing the data of the first interleaved data stream to the N sub-data streams in a round-robin manner based on the interleaving granularity of the first interleaved data stream.

9. The method according to any one of claims 1 to 8, wherein the method further comprises:
determining an FEC codeword boundary of each of the N sub-data streams.

10. The method according to claim 9, wherein the determining an FEC codeword boundary of each of the N sub-data streams comprises:
determining the FEC codeword boundary of each of the N sub-data streams based on an FEC codeword characteristic.

11. The method according to claim 10, wherein the determining the FEC codeword boundary of each of the N sub-data streams based on an FEC codeword characteristic comprises:
in each sub-data stream, separately performing characteristic value verification based on an assumed FEC codeword boundary, and determining the FEC codeword boundary of each sub-data stream based on a verification result.

12. The method according to claim 10 or 11, wherein there is a cyclic shift relationship between FEC codewords of each of the N sub-data streams, and the determining the FEC codeword boundary of each of the N sub-data streams based on an FEC codeword characteristic comprises:
performing an inverse cyclic shift on the obtained FEC codewords of each of the N sub-data streams; and
determining the FEC codeword boundary of each of the N sub-data streams after the inverse cyclic shift based on the FEC codeword characteristic.

13. The method according to claim 9, wherein the determining an FEC codeword boundary of each of the N sub-data streams comprises:
determining an FEC codeword boundary of a third sub-data stream in the N sub-data streams; and
determining FEC codeword boundaries of other sub-data streams in the N sub-data streams based on the FEC codeword boundary of the third sub-data stream.

14. The method according to claim 13, wherein the FEC codeword boundary of the third sub-data stream is located in a 1^{st} column of the third sub-data stream, and
the determining FEC codeword boundaries of other sub-data streams in the N sub-data streams based on the FEC codeword boundary of the third sub-data stream comprises:
the FEC codeword boundaries of the other sub-data streams are located in respective 1^{st} columns of the other sub-data streams or adjacent columns of the 1^{st} columns.

15. The method according to any one of claims 1 to 14, wherein the first interleaved data stream does not comprise a periodic alignment data segment, and the periodic alignment data segment comprises an alignment marker, a frame alignment word, or pilot data.

16. The method according to any one of claims 1 to 15, wherein an FEC encoding mode of the first interleaved data stream is FEC encoding of a non-concatenated code or FEC encoding of a concatenated code.

17. The method according to any one of claims 1 to 16, wherein N is 4 or 8.

18. The method according to any one of claims 1 to 17, wherein an interleaving type of the first interleaved data stream is symbol interleaving or convolutional interleaving.

19. The method according to any one of claims 1 to 18, wherein the method is performed by a physical layer PHY chip, a forwarding device, or a pluggable module.

20. The method according to any one of claims 1 to 19, wherein a lane rate of the first interleaved data stream is greater than or equal to 200 gigabits per second Gbps.

21. An Ethernet device, wherein the Ethernet device is configured to perform the method according to any one of claims 1 to 20.

22. A chip, wherein the chip is configured to perform the method according to any one of claims 1 to 20.

23. A communication system, wherein the communication system comprises a transmitter device and a receiver device, wherein
the receiver device is configured to perform the method according to any one of claims 1 to 20.
